# EUROPEAN PATENT APPLICATION

(11) **EP 4 779 876 A1**
(43) Date of publication of application: **22.07.2026**
(21) Application number: 26151258.6
(22) Date of filing: 12.01.2026
(51) Int. Cl.: H03L 7/089, H03L 7/099, H03L 7/18

(54) **ADAPTIVE BANDWIDTH TRACKING IN PHASE LOCKED LOOP WHICH TRACKS REFERENCE AND VCO FREQUENCY**

(30) Priority: 20.01.2025 IN 202541004604
(71) Applicant: NXP USA, Inc., Austin, TX 78735 (US)
(72) Inventor: Goyal, Saurabh, 5656AG Eindhoven (NL); Sinha, Anand Kumar, 5656AG Eindhoven (NL); Omer, Ateet, 5656AG Eindhoven (NL)
(74) Representative: Schwarzweller, Thomas

(57) **Abstract**

A PLL method and apparatus are provided with a phase-frequency detector, charge pump, loop filter, voltage controlled ring oscillator, and feedback clock divider that is configured with a multiplication feedback integer (MFI) value for generating a PLL clock output signal, where the charge pump includes a current bias circuit which dynamically scales an input reference current under control of the MFI value to generate the charge pump control current so that a PLL bandwidth of the PLL adaptively tracks a frequency of the input reference signal and a frequency of the PLL clock output signal.

## Description

### BACKGROUND OF THE INVENTION

### Field of the Invention

The present invention is directed in general to electronic circuits. In one aspect, the present invention relates to phase locked loop circuits.

### Description of the Related Art

A phase-locked loop or phase-locked loop (PLL) is a control system that generates an output signal whose phase is related to the phase of an input signal. Generally speaking, PLLs can be implemented as electronic circuits having a variable frequency oscillator and a phase and/or frequency detector in a feedback loop where the oscillator generates a periodic signal which is fed back over a feedback divider to the phase/frequency detector for comparison with the phase/frequency of the input periodic signal so that the oscillator can be adjusted to keep the phases/frequencies matched. Generally, PLL control systems operate over a wide range of frequencies and over a wide range of process, voltage and temperature (PVT) variations. In some applications, the bandwidth of the PLL needs to vary less across reference and VCO frequency changes, but the PLL bandwidth may vary with other parameters (e.g., process, voltage and temperature (PVT) variations, the feedback divider factor (M), PLL design parameters, and the like) which introduce undesired variance into the PLL bandwidth and degrade the loop stability of the PLL. For example, the PLL bandwidth is inversely proportional to the feedback divider factor (M) for the same output VCO frequency, where the PLL bandwidth will decrease if M is larger, and the PLL bandwidth will increase if M is smaller. In other words, the PLL bandwidth gets smaller if the input reference frequency is lower for a fixed output VCO frequency, and the PLL bandwidth gets higher if the input reference frequency is higher for a fixed output VCO frequency. In some applications, the large variations in bandwidth across reference and VCO frequency change is not allowed.

Since the current taken by the VCO for a conventional PLL circuit depends only on VCO output frequency (and is independent of the input reference frequency), it is not feasible to control the bandwidth using VCO current only. Conventional bandwidth stabilization circuits use VCO current to adjust the PLL bandwidth, but it does not accurately track the bandwidth with the input reference frequency change. For example, some conventional PLL control system solutions include a dual charge pump circuit in the PLL to track the input reference signal frequency, but the additional circuitry affects the loop dynamics and complexity in the PLL design. Other conventional PLL control system solutions have attempted to track the bandwidth with the VCO output frequency by adding a fraction of the VCO current into the charge pump current (*i*_{CP}) to effectively control the bandwidth, but such solutions do not track the input reference frequency. As a result, the existing solutions for adaptively tracking PLL bandwidth with both the input reference frequency and VCO output frequency are extremely difficult at a practical level.

### BRIEF DESCRIPTION OF THE DRAWINGS

The present invention may be understood, and its numerous objects, features and advantages obtained, when the following detailed description is considered in conjunction with the following drawings.
Figure 1 illustrates a high-level block diagram of a phase locked loop (PLL) circuit having a phase frequency detector, charge pump with current bias circuit, loop filter and voltage controlled oscillator connected in feedback with a feedback divider to adaptively control the PLL bandwidth in accordance with selected embodiments of the present disclosure.
Figure 2 depicts a plot of the VCO ring current as a function of the feedback divider factor for two reference frequencies in a conventional PLL circuit.
Figure 3 depicts a plot of the VCO ring current as a function of the VCO output frequency for a conventional PLL circuit.
Figure 4 depicts a simplified graphical representation of the bandwidth and charge-pump current as a function of the feedback divider factor for a conventional PLL circuit.
Figure 5 depicts a simplified graphical representation of the charge-pump current and bandwidth as a function of the feedback divider factor for a PLL circuit in accordance with selected embodiments of the present disclosure.
Figure 6 depicts a circuit schematic diagram of a charge pump current bias circuit which is controlled using feedback division factor for adjusting the charge pump current so that the PLL bandwidth is substantially constant across a range of feedback divider factor values in accordance with selected embodiments of the present disclosure.
Figure 7 depicts a simulated plot of different charge pump currents as a function of the feedback divider factor with change in reference frequency generated with different VCO frequencies by conventional PLL circuit current without any bandwidth tracking mechanism.
Figure 8 depicts a simulated plot of different charge pump currents as a function of the feedback divider factor with change in reference frequency generated with different VCO frequencies by a PLL circuit with a bandwidth tracking mechanism in accordance with selected embodiments of the present disclosure.
Figure 9 depicts a simulated plot of the PLL bandwidth as a function of the feedback divider factor in a PLL which includes a feedback divider circuit so that the bandwidth values are substantially uniform as the MFI values change in accordance with selected embodiments of the present disclosure.
Figure 10 depicts a simplified flowchart diagram showing the logic for controlling the operation of a PLL in accordance with selected embodiments of the present disclosure.

### DETAILED DESCRIPTION

An adaptive bandwidth tracking phase locked loop (PLL) method and apparatus are described for using a charge pump current bias circuit that is controlled by a feedback division factor to scale the charge pump current so that the PLL bandwidth will track with both the input reference frequency and VCO output frequency. Instead of using the VCO ring current (which is a fractional portion of the VCO current) to modify the charge pump current, a compact charge pump current bias circuit is provided which tracks the integer portion of the loop division ratio to modify the charge pump current, thereby enabling the PLL bandwidth to track the input reference frequency and the VCO output frequency. In selected embodiments, the disclosed charge pump current bias circuit is connected to receive an input reference current that is a proportional to absolute temperature (*i*_{PTAT}), and includes a plurality of FET switches connected in parallel between the charge pump output and a ground supply reference voltage as a current mirror. By applying a digital MFI value to switch the gates of the plurality of FET switches between the reference current and the ground supply reference voltage, the input reference current (*i*_{PTAT}) is scaled to generate a charge pump current (*i*_{CP}) so that the PLL bandwidth tracks the input reference frequency and the VCO output frequency. In contrast to previous solutions which require complex analog circuitry, the disclosed charge pump current bias circuit can be used to enable PLL bandwidth tracking for changes in the input reference frequency or VCO output frequency.

Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified schematic circuit block diagrams without including every circuit element or detail in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to illustrate specific details. Furthermore, the described features, advantages, and characteristics of the invention may be combined in any suitable manner in one or more embodiments. One skilled in the relevant art will recognize, in light of the description herein, that the embodiments can be practiced without one or more of the specific features or advantages of a particular embodiment. In other instances, additional features and advantages may be recognized in certain embodiments that may not be present in all embodiments. For example, selected aspects are depicted with reference to simplified circuit schematic drawings without including every circuit detail in order to avoid limiting or obscuring the present invention. Such details are well known and not considered necessary to teach one skilled in the art of how to make or use the present invention.

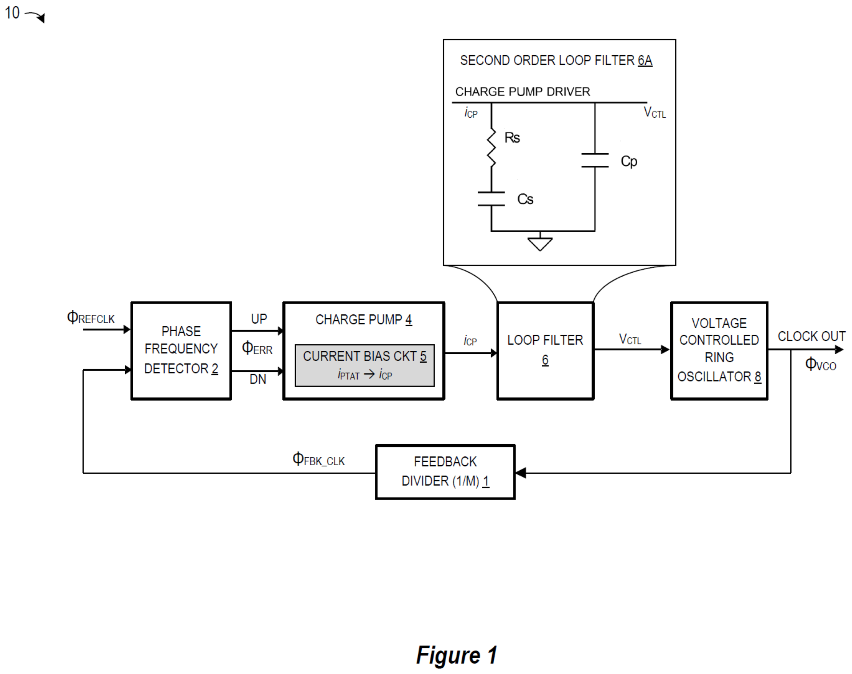

To provide additional details for a contextual understanding of the present disclosure, reference is now made to Figure 1 which depicts a high-level block diagram of a phase locked loop (PLL) circuit 10 having a phase frequency detector 2, charge pump 4 with current bias circuit 5, loop filter 6, and voltage controlled oscillator 8 connected in feedback with a feedback divider 1 to generate an output clock signal frequency φ_{VCO} within a PLL bandwidth that is adaptively controlled so that the charge pump current tracks the PLL bandwidth in accordance with selected embodiments of the present disclosure. As depicted, the PLL circuit 10 is connected to receive a reference clock signal φ_{REFCLK}, and to generate an output clock signal CLOCK OUT that is characterized with a PLL bandwidth frequency parameter that defines the PLL loop characteristics for operational functionality (such as its stability, tuning speed, and phase noise shaping). In short, the PLL bandwidth is a frequency that characterizes the loop's characteristics, such as tuning speed, stability, and phase noise shaping. As will be appreciated, the reference clock signal φ_{REFCLK} may be a periodic signal that oscillates at a fixed frequency and may have any suitable waveform shape, such as a square wave or a sinusoid wave. In selected embodiments, the reference clock signal φ_{REFCLK} may be generated by a crystal-controlled oscillator that oscillates at a fixed frequency (e.g., 24 MHz). In addition, the output clock signal CLOCK OUT may have a frequency profile that is determined by a target frequency profile for the PLL circuit 10. For example, the output clock signal CLOCK OUT may be a chirp signal having a periodic function with a frequency that varies with respect to time.

The depicted phase frequency detector 2 is connected and configured to receive the reference clock signal φ_{REFCLK} and a feedback signal φ_{FSK_CLK}, and to generate an output phase difference signal φ_{ERR} comprising up/down values UP, DN based on the difference between the reference clock signal φ_{REFCLK} and the feedback signal φ_{FBK_CLK} phase difference. Phase difference signal UP, DN may be indicative of a phase difference between the reference clock signal φ_{REFCLK} and the feedback signal φ_{FSK_CLK}. To generate the phase difference signal UP, DN, the phase frequency detector 2 may use any suitable phase frequency determination techniques known in the art, including but not limited to a digital or phase detector (e.g., a bang-bang phase detector) which generates a value of positive one or a value of negative one based on the sign of the phase difference between the reference clock signal φ_{REFCLK} and the feedback signal φ_{FBK_CLK}.

The phase difference signal UP, DN output from the phase frequency detector 2 feeds into the charge pump 4 which is capable of generating a current with either a positive or negative polarity, based on control signals coming from the PFD 2. The charge pump 4 may include first and second current sources connected, respectively, to VDD and ground supply reference voltages. In response to the phase difference signal UP, DN, the charge pump 4 generates a charge pump output current *i*_{CP}.

The charge pump output current *i*_{CP} may be supplied to the low pass filter (LPF) 6 which includes circuitry for producing a voltage control output signal (V_{CTL}) which may correspond to a filtered version of phase difference signal UP, DN. Though any suitable loop filter circuit may be used, the loop filter 6 may be implemented with second order passive loop filter 6A which includes a series-connected resistor Rs and a relatively large capacitor Cs connected in parallel with a relatively small capacitor Cp to receive the charge pump output current *i*_{CP} and to generate the voltage control output signal (V_{CTL}) as shown.

The voltage-controlled ring oscillator (VCO) 8 is connected and configured to generate the VCO output clock signal CLOCK OUT that is controlled by the voltage control output signal (V_{CTL}) from the loop filter 6. The output clock signal CLOCK OUT may be connected to provide a clock signal for other circuitry (not shown).

The VCO clock output signal CLOCK OUT is also provided with the output clock signal frequency φ_{VCO} to the frequency divider 1 which is connected and configured to generate a feedback signal φ_{FSK_CLK} to the phase frequency detector 2 that is a fraction (1/M) of the output clock signal frequency φ_{VCO}. In selected embodiments, the frequency divider 1 is configured to receive the output clock signal φ_{VCO}, and to generate the feedback signal φ_{FBK_CLK} based on a frequency divider control signal which may be indicative of a division factor (M) to be used for dividing the frequency of output clock signal φ_{VCO}. Frequency divider 1 may generate the feedback signal φ_{FSK_CLK} to have a frequency that is approximately equal to the quotient of the frequency of output clock signal φ_{VCO} divided by M.

Ignoring for the moment the charge pump current bias circuit 5, the components 1, 2, 4, 6, 8 are connected to operate as a conventional PLL circuit which is characterized by a PLL bandwidth parameter that is inversely proportional to the loop division factor M. This behavior is seen in the equation for the loop bandwidth cut-off frequency Fc = (Rs * *i*_{CP} *** K_{VCO})/(M*2*π), where *i*_{CP} is the charge pump current, Kvco is the VCO gain, and M is the effective feedback divider factor. In situations where the input reference frequency (φ_{REF}) is less than the output clock signal frequency φ_{VCO}, M will be a relatively larger value. And for VCO output clock frequency φ_{VCO} that is the same as the input reference frequency (φ_{REF}), M would be 1. As seen from the foregoing, for fixed VCO frequency, the PLL bandwidth Fc gets smaller for lower input reference frequency values (φ_{REF}), and Fc gets larger for higher input reference frequency values (φ_{REF}). The resulting bandwidth instability cannot be addressed by using the output current from the VCO 8 since it depends only on the frequency of output clock signal φ_{VCO} (and is independent of the input reference frequency). And while previous PLL solutions have proposed tracking the bandwidth with the VCO output frequency by adding a fraction of the VCO current into the charge pump current (*i*_{CP}), such solutions do not result in the bandwidth tracking the input reference frequency.

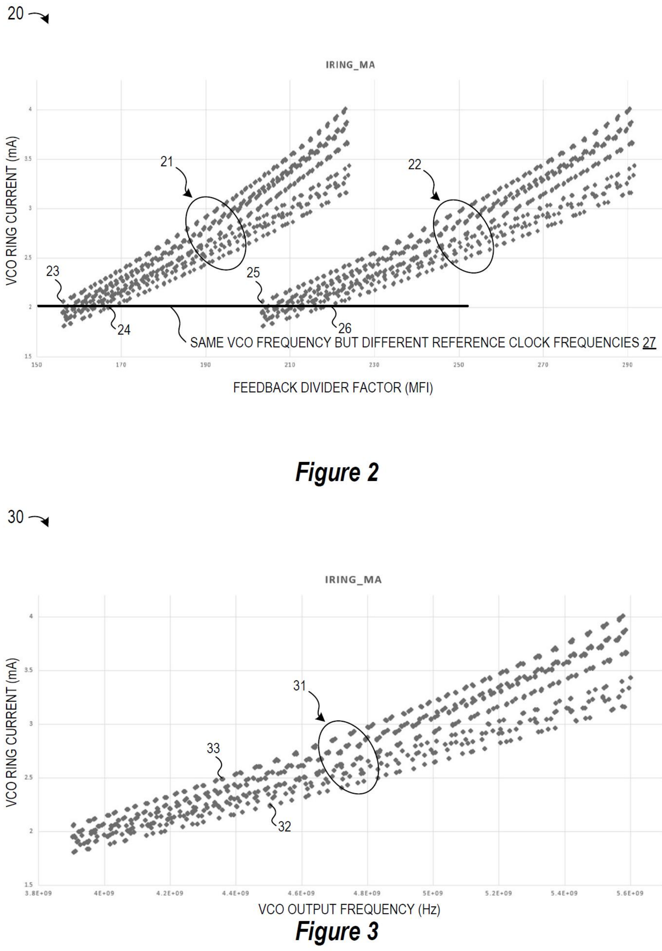

To illustrate the performance limitations of conventional PLL control systems, reference is now made to Figure 2 which depicts a plot 20 of the VCO ring current values (in milliamps) as a function of the feedback divider factor (MFI). As depicted, the VCO ring currents across process, voltage and temperature 21-22 represent a range of values for different input reference clock frequencies. For example, the VCO ring current plot 23 increases as a function of the increasing feedback divider factor values (M) which results in increasing VCO output frequencies for the PLL circuit. In addition, each of the VCO ring current plots 24-26 increase as a function of the increasing feedback divider factor values (MFI) which results in increasing VCO output frequencies for the PLL circuit. However, horizontal black line 27 shows that the same VCO ring current value (e.g., 2 mA) can be generated for the same VCO output frequency from different input reference clock frequencies (by means of different feedback divider factor values MFI), confirming that, for the same output VCO frequency, the VCO ring oscillator current is independent of reference clock frequency. In particular, if the input reference clock frequency is 25MHz and the VCO output frequency is 5GHz, MFI will be 5GHz/25MHz = 200. Similarly, if the input reference clock frequency is 50MHz and the VCO output frequency is 5GHz, MFI will be 5GHz/50MHz = 100, resulting in an increase of the bandwidth by a factor of 2. But as the VCO output frequency is same for both of the cases (5GHz), the VCO ring oscillator current will be same. This demonstrates that that the conventional PLL bandwidth tracking solution -- of adding some fractional ring oscillator current into the charge pump current - will not modify the PLL bandwidth as a function of the input reference frequency because the VCO ring current is not changing as a function of the feedback divider factor value MFI. In other words, since the VCO ring current is independent of reference frequency, adding a fraction of the VCO current will not help in tracking the feedback divider factor values (MFI).

Another illustration of the performance limitations of conventional PLL control systems is provided in Figure 3 which depicts a plot 30 of the VCO ring current values 31 (in milliamps) across process, voltage and temperature as a function of the VCO output frequency. In particular, each of the VCO ring current plots 32, 33 increases linearly as a function of the VCO output frequency, where less VCO ring current is required to generate lower VCO output frequencies, and more VCO ring current is required to generate higher VCO output frequencies. Since the VCO ring currents 31 are increasing with the VCO output frequency, the conventional PLL bandwidth tracking solutions will add some fractional amount of the VCO ring oscillator current into the charge pump current to increase the PLL bandwidth as a function of the VCO output frequency, but this PLL bandwidth modification will not track the change in input reference frequency.

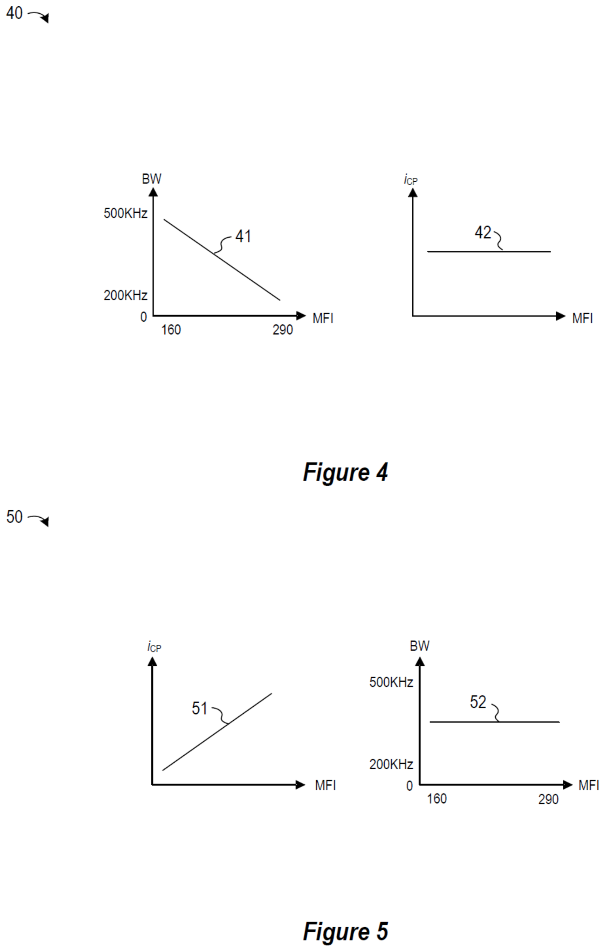

To further illustrate the performance limitations of conventional PLL control systems, reference is now made to Figure 4 which depicts simplified graphical representations 40 of the bandwidth 41 and charge-pump current *i*_{CP} 42 as a function of the integer part of the feedback divider factor (MFI) for a conventional PLL circuit. In particular, the bandwidth plot 41 shows that the PLL bandwidth decreases (e.g., is inversely proportional) as the MFI value increases, which is confirmed by the loop bandwidth cut-off frequency equation for the Fc = (Rs ** i*_{CP} * K_{VCO})/(M*2*π). In an example scenario, the bandwidth reduces from approximately 480KHz to 186KHz as the MFI values increase from approximately 155 to 290. In addition, the charge pump current plot 42 shows that the charge pump current *i*_{CP} is constant for a given VCO output clock signal frequency φ_{VCO} and does not change as the MFI value increases. And even with changes in the input reference frequency, the charge pump current *i*_{CP} does not change.

Referring back to Figure 1, the phase locked loop (PLL) circuit 10 may be configured to include a charge pump current bias circuit 5 to address these deficiencies with conventional PLL circuits and others known to those skilled in the art. As disclosed herein, the charge pump current bias circuit 5 is connected and configured to scale the charge pump current *i*_{CP} generated by the charge pump 4 in response to a feedback division factor so that the PLL bandwidth will track with both the input reference frequency and VCO output frequency. Stated another way, the charge pump current bias circuit 5 enables the charge pump current *i*_{CP} to adaptively change (e.g., increase) as the feedback factor increases for decrease in input reference frequency to keep VCO frequency constant, thereby keeping the PLL bandwidth constant and controlled between approximately 200KHz and 400KHz as the MFI values increase.

To understand the feedback control role of the feedback factor M in the performance of the PLL circuit 10, the VCO output clock signal frequency φ_{VCO} = M * φ_{REF}. Typically, the feedback divider 1 may be configured with the feedback divider factor value M = MFI + (MFN/MFC), where MFI is the integer portion of the feedback divider factor, MFN is the numerator of the fractional portion of the feedback divider factor, and MFD is the denominator of the fractional portion of the feedback divider factor. With this understanding, the VCO output clock signal frequency φ_{VCO} = [MFI+(MFN/MFD)] * φ_{REF}. Each of the feedback divider factor values MFI, MFN, MFD may be configured in the feedback divider 1 as multi-bit digital values for the operation of the PLL. For example, the MFI value may include 9 bits<8:0>, varying from 0 to 511 codes, though any desired number of bits may be used.

In order to track the PLL bandwidth with the input reference frequency and VCO output frequency, the charge pump current bias circuit 5 is configured to generate a charge pump current *i*_{CP} by applying the feedback divider value MFI to scale a reference current. In selected embodiments, the charge pump current bias circuit 5 is connected to receive the reference current from a bandgap reference source, such as a PTAT current that is approximately constant across process and voltage. In addition, the charge pump current bias circuit 5 is configured to generate the charge pump current *i*_{CP} by scaling the PTAT current using the feedback divider value MFI. The scaling may be implemented by dividing the MFI code by a predetermined 2ⁿ factor (e.g., 16), where n could be any positive integer. In an example embodiment of the proposed architecture, the MFI code may be divided by 16, where an approximation of the quotient value being computed by taking the 5 most significant bits of the 9-bit MFI code. For example, if the MFI code (255) of 011111111 is divided by 16, the decimal result of the quotient is 15.9375. As will be appreciated, a good approximation of the quotient may be obtained from the 5 MSB bits of the MFI code (01111) which is 16 which is approximately equal to the divided decimal value. Using the quotient value, the charge pump current bias circuit 5 is configured to scale the PTAT current (*i*_{PTAT}) UP or DOWN based on the 5 MSB bits. For example, if 5 MSB output is 16, then the charge pump current *i*_{CP} will be 16**i*_{PTAT}. Stated more broadly, for any quotient value X, the charge pump current bias circuit 5 is configured to output the charge pump current *i*_{CP} = X**i*_{PTAT}. In this way, the charge pump current bias circuit 5 is configured to scale the charge pump current *i*_{CP} based on the MFI value, where a larger MFI value means more charge pump current to keep the PLL bandwidth approximately constant, and a smaller MFI value means lower charge pump current to keep the PLL bandwidth approximately constant. In addition, this approach eliminates the need for large scaling down of the CCO current (mA) which can lead to mismatch between CCO current and charge pump current (µA).

To illustrate the performance improvements of the PLL circuit in accordance with the present disclosure, reference is now made to Figure 5 which depicts a simplified graphical representation of the charge-pump current 51 and bandwidth 52 as a function of the integer part of the feedback divider factor (MFI). In particular, the charge-pump current plot 51 shows that the charge pump current *i*_{CP} is increasing with larger MFI values. By controlling the charge pump current *i*_{CP} to be proportional to the MFI values, the charge pump current *i*_{CP} increases when the feedback factor is increasing. By increasing the charge pump current *i*_{CP}, the pumping of additional charge pump current effectively cancels out the inverse relation (shown in the bandwidth plot 41 of Figure 4) so that the bandwidth plot 52 will remain constant. As a result, the bandwidth 52 shows that the PLL bandwidth is constant and does not change as the MFI value increases. In other words, changes in the input reference frequency cause the charge pump current *i*_{CP} to increase which helps keep the PLL bandwidth constant.

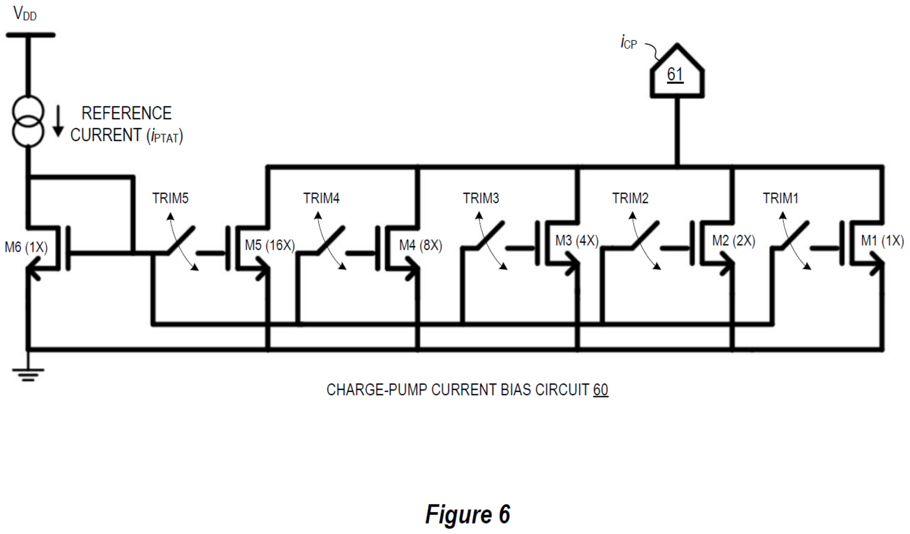

To provide additional details for an improved understanding of selected embodiments of the present disclosure, reference is now made to Figure 6 depicts which depicts a circuit schematic diagram 60 of a charge pump current bias circuit 61 which is controlled using feedback division factor for adjusting the charge pump current so that the PLL bandwidth is substantially constant across a range of feedback divider factor values. As depicted, the charge pump current bias circuit 61 includes a first diode-connected FET M6 having a unit size (1X) connected between a bandgap reference circuit and ground to receive an input reference current, such as a current that is proportional to absolute temperature (e.g., *i*_{PTAT}). In addition, the charge pump current bias circuit 61 includes a plurality of FET transistors M1-M5 connected with the first diode-connected FET M6 as a current mirror circuit, where the first transistor M1 has a unit size (1X), the second transistor M2 has a 2X unit size, the third transistor M3 has a 4X unit size, the fourth transistor M4 has a 8X unit size, and the fifth transistor M5 has a 16X unit size. With the individual MSBs of the MFI value applied as trim values (TRIM1-TRIM5) to switch the gates of the FET transistors M1-M5 between the reference current and ground, the charge pump current *i*_{CP} is generated from the reference current *i*_{PTAT} under control of the MFI values. In particular, the plurality of FET transistors M1-M5 are source-drain connected between the charge pump current output pad 61 and ground, with the respective bits of the MFI value applied as trim values (TRIM1-TRIM5) to the selectively connect the gates of the FET transistors M1-M5 to receive the the input reference current (*i*_{PTAT}). By applying a digital MFI value to switch the gates of the plurality of FET transistors M1-M5 between the input reference current (*i*_{PTAT}) and the ground supply reference voltage, the input reference current (*i*_{PTAT}) is scaled UP or DOWN to generate a charge pump current (*i*_{CP}) so that the PLL bandwidth tracks the input reference frequency and the VCO output frequency. In contrast to previous solutions which require complex analog circuitry, the disclosed charge pump current bias circuit can be used to enable PLL bandwidth tracking for changes in the input reference frequency or VCO output frequency.

To provide an example illustration where the input reference clock signal frequency φ_{REFCLK} = 19.2MHz and the VCO output clock signal frequency φ_{VCO} = 5.5GHz, the MFI will be 286 (100011110). In this case, the charge pump current bias circuit 61 applies the 5 MSB of the MFI value to turn ON the transistors M1, M5, thereby scaling the reference current to generate the charge pump current *i*_{CP} = *i*_{PTAT}*(DEC(10001)) = 17**i*_{PTAT}. In another example where the input reference clock signal frequency φ_{REFCLK} = 25MHz and the VCO output clock signal frequency φ_{VCO} = 5.5GHz, the MFI will be 220 (011011100). In this case, the charge pump current bias circuit 61 applies the 5 MSB of the MFI value to turn ON the transistors M1, M3, M4, thereby scaling the reference current to generate the charge pump current *i*_{CP} = *i*_{PTAT}*(DEC(01101)) = 13**i*_{PTAT}.

For a lower input reference clock signal frequency φ_{REFCLK} and a higher VCO output clock signal frequency φ_{VCO}, the MFI value will be higher. Without MFI scaling, the PLL bandwidth would be smaller (as shown with the bandwidth plot 41 in Figure 4). However, to stabilize the PLL bandwidth, the charge pump current bias circuit 61 applies the higher MFI value to scale UP the charge pump current *i*_{CP}, thereby keeping the PLL bandwidth substantially constant. And for a higher input reference clock signal frequency φ_{REFCLK} and a lower VCO output clock signal frequency φ_{VCO} where the MFI value will be smaller, the charge pump current bias circuit 61 applies the smaller MFI value to scale DOWN the charge pump current *i*_{CP}, thereby keeping the PLL bandwidth substantially constant from what it would otherwise be if without MFI scaling (as shown with the bandwidth plot 41 in Figure 4).

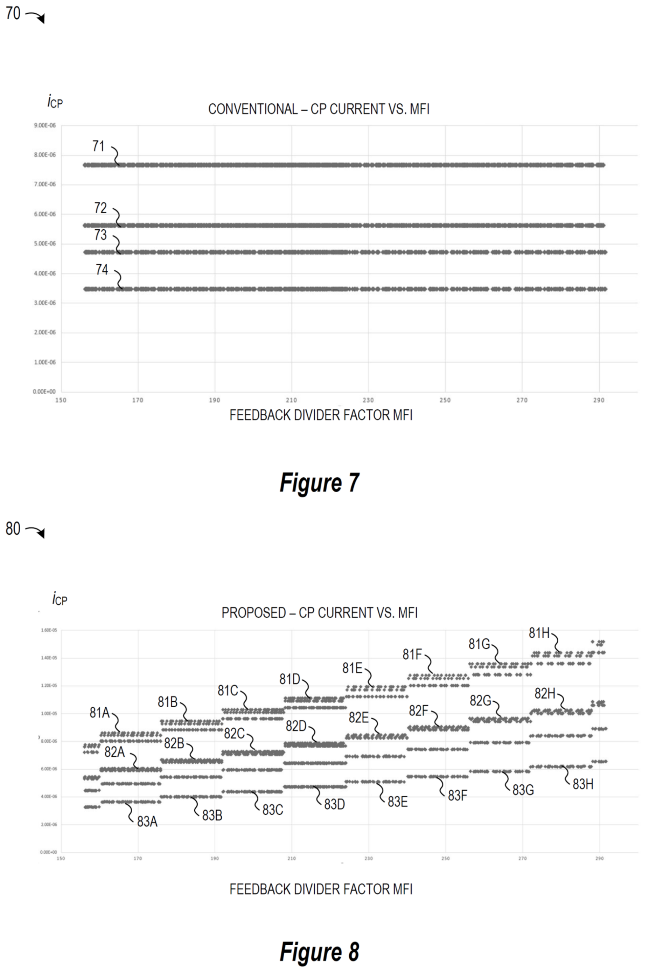

To comparatively illustrate the performance benefits of the present disclosure, reference is now made to Figure 7 which depicts a simulated plot 70 of different charge pump currents 71-74 as a function of the feedback divider factor MFI generated with different VCO frequencies by conventional PLL circuit current without any bandwidth tracking mechanism. In particular, the charge pump current plot 71 is depicted for a first VCO output clock signal frequency φ_{VCO} to show that the charge pump current *i*_{CP} 71 has a constant value (~7.70E-06 amps) which does not change as the MFI value increases. In addition, the charge pump current plot 72 for a second, smaller VCO output clock signal frequency φ_{VCO} shows that the charge pump current *i*_{CP} 72 has a smaller constant value (~6.70E-06 amps) which does not change as the MFI value increases. In addition, the depicted charge pump current plot 73 for a third, smaller VCO output clock signal frequency φ_{VCO} shows that the charge pump current *i*_{CP} 73 has a smaller constant value (~4.75E-06 amps), and the depicted charge pump current plot 74 for a fourth, smaller VCO output clock signal frequency φ_{VCO} shows that the charge pump current *i*_{CP} 74 has a smaller constant value (~3.45E-06 amps). As depicted, even with changes in the MFI codes, a conventional PLL circuit which does not include MFI tracking mechanism will generate a constant charge pump current *i*_{CP} for a given VCO output clock signal frequency φ_{VCO} which is constant across MFI codes.

To comparatively illustrate the performance benefits of the present disclosure, reference is now made to Figure 8 which depicts a simulated plot 80 of different charge pump currents 81-83 as a function of the feedback divider factor MFI generated with different VCO frequencies by a PLL circuit with a bandwidth tracking mechanism in accordance with selected embodiments of the present disclosure. In particular, the charge pump current plot 81 is depicted for a first VCO output clock signal frequency φ_{VCO} to show that the charge pump current *i*_{CP} 81 has a sequence of stepped values 81A-H which increase (e.g., from approximately 8.80E-06 amps to 1.44E-05 amps) as the value of the feedback divider factor MFI increases. In addition, the charge pump current plot 82 for a second, smaller VCO output clock signal frequency φ_{VCO} shows that the charge pump current *i*_{CP} 82 has a sequence of stepped values 82A-H which increase (e.g., from approximately 6.00E-06 amps to 1.02E-05 amps) as the MFI value increases. In addition, the charge pump current plot 83 for a third, smaller VCO output clock signal frequency φ_{VCO} shows that the charge pump current *i*_{CP} 83 has a sequence of stepped values 83A-H which increase (e.g., from approximately 3.60E-06 amps to 6.10E-06 amps) as the MFI value increases. In accordance with the present disclosure, any time there is a change in the MFI value, the charge pump current is automatically adjusted or scaled on the basis of the MFI value so that the PLL bandwidth is adjusted for each loop division factor by applying the MFI value as a digital control for an analog current mirror so that the charge pump current is scaled in real time for each loop division factor.

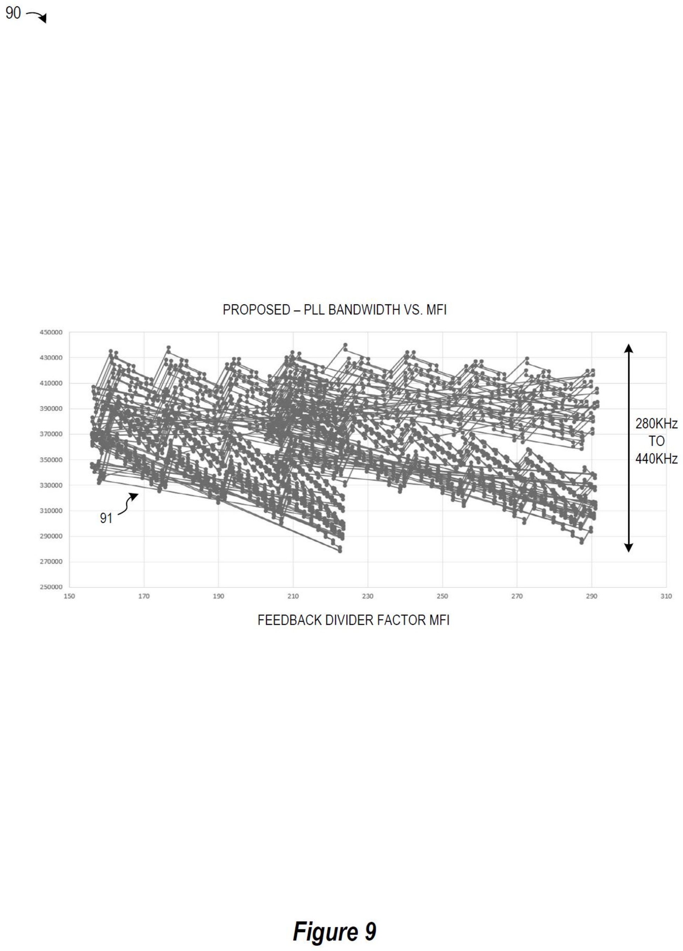

As disclosed herein, the PLL circuit which includes the MFI tracking mechanism will generate stepped, increasing charge pump currents that increase as the MFI values increase to help with tracking the bandwidth. The improved bandwidth tracking performance is illustrated in Figure 9 which depicts a simulated plot 91 of the PLL bandwidth as a function of the feedback divider factor in a PLL which includes a feedback divider circuit so that the bandwidth values are substantially uniform as the MFI values increase in accordance with selected embodiments of the present disclosure. In contrast to the convention PLL circuits which have a 3X variation in bandwidth because they do not scale the charge pump current, the bandwidth remains substantially uniform across the MFI values, keeping the PLL bandwidth between 280KHz to 440KHz (which is approximately 1.5X variation in bandwidth). This results in an effective improvement of 2X in variation from conventional PLL performance, and complies with industry standards, such as the USB3.2 display port mode specification which requires that the bandwidth should be more than 200KHz (for spread spectrum clock application) and should be less than 500KHz.

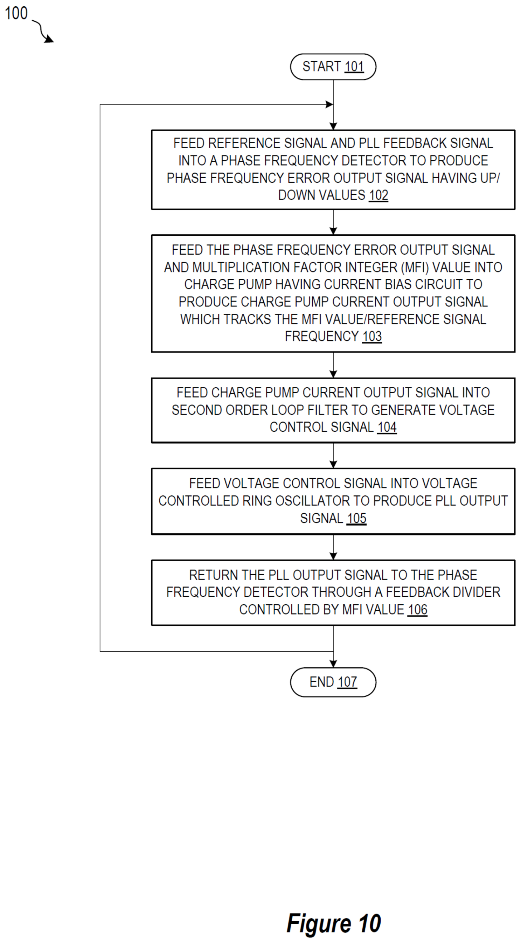

Turning now to Figure 10, there is shown a simplified flowchart diagram 100 showing the logic for controlling the operation of a PLL in accordance with selected embodiments of the present disclosure. When the operation of the PLL starts (101), the PLL circuitry feeds a reference signal and a PLL feedback signal into the phase frequency detector to produce a phase frequency error output signal comprising up/down values (step 102). Next, the PLL circuitry feeds the phase frequency error output signal and a multiplication factor integer (MFI) value into a charge pump having a current bias circuit to produce a charge pump current output signal which tracks the MFI value/reference signal frequency (step 103). During step 103, the current bias circuit may be implemented with a digitally controlled current mirror which scales an input reference current in response to the MFI value which is applied as a sequence of FET trim gate control signals to the digitally controlled current mirror. At step 104, the DPLL circuitry feeds the charge pump current output signal into a second order loop filter to generate a voltage control signal. At step 105, the voltage control signal is fed into a voltage-controlled ring oscillator to produce a PLL output signal. At step 106, the PLL circuit returns the PLL output signal control signal to the phase frequency detector through a feedback divider that is controlled by the MFI value and the steps 102-106 are repeated until the method ends (step 107).

A PLL method and apparatus are provided with a phase-frequency detector, charge pump, loop filter, voltage controlled ring oscillator, and feedback clock divider that is configured with a multiplication feedback integer (MFI) value for generating a PLL clock output signal, where the charge pump includes a current bias circuit which dynamically scales an input reference current under control of the MFI value to generate the charge pump control current so that a PLL bandwidth of the PLL adaptively tracks a frequency of the input reference signal and a frequency of the PLL clock output signal.

By now it should be appreciated that there is provided herein a phase-locked loop (PLL) circuit and method of operation for generating a PLL clock output signal. In the disclosed methodology and apparatus, the PLL includes a phase-frequency detector (PFD) that is connected to receive an input reference signal and a feedback clock signal as inputs and configured to produce a PFD error output signal. In addition, the PLL includes a charge pump connected to receive the PFD error output signal as an input and configured to produce a charge pump control current which tracks a multiplication feedback integer (MFI) value. The PLL also includes a loop filter connected to receive the charge pump control current and configured to produce a voltage control signal by filtering the charge pump control current. In addition, the PLL includes a voltage controlled ring oscillator which is connected to receive voltage control signal and configured to produce a PLL clock output signal. The PLL also includes a feedback clock divider connected to receive the PLL clock output signal as an input and configured with the MFI value to produce the feedback clock signal for return to the phase-frequency detector. In the disclosed PLL, the charge pump includes a current bias circuit which dynamically scales an input reference current under control of the MFI value to generate the charge pump control current so that a PLL bandwidth of the PLL adaptively tracks a frequency of the input reference signal and a frequency of the PLL clock output signal. In selected embodiments, the current bias circuit includes a current mirror connected with a trimming circuit to generate the charge pump control current by adding or subtracting current to the input reference current under control of the MFI value. In such embodiments, a plurality of the most significant bits of the MFI value may be applied to the trimming circuit to generate the charge pump control current. In selected embodiments, the PLL may also include a bandgap reference current generator which generates the input reference current that varies proportionally as a function of temperature. In such embodiments, the current bias circuit may include a current mirror that is connected to receive the input reference current at diode-connected gate of a first field effect transistor (FET) device and that is configured to generate the charge pump control current by supplying the input reference current under control of the MFI value to one or more gates of a plurality of second FET devices connected in parallel between a charge pump control current output and the ground supply reference voltage. In selected embodiments, the first FET device may have a unit size. In addition, the plurality of second FET devices may include a first unit-sized FET device and a plurality of differently sized FET devices that are source-drain connected between the charge pump control current output and the ground supply reference voltage and that have respective gate terminals respectively connected to receive the input reference current over a corresponding connection switch that is controlled by a trim control value from the MFI value.

In another form, there is provided a phase locked loop (PLL) circuit with adaptive bandwidth tracking and associated method of operation. In the disclosed method, a phase-frequency detector generates a phase-frequency error measure by detecting a phase difference between an input reference signal and a feedback clock signal. The disclosed method also generates a charge pump control current which tracks a multiplication feedback integer (MFI) value in response to the phase-frequency error measure. In selected embodiments, the charge pump control current is generated by generating a reference current, and providing the reference current as an input to a current mirror connected with a trimming circuit to generate the charge pump control current by adding or subtracting current to the input reference current under control of the MFI value. In such embodiments, the reference current may be generated by generating a current that varies proportionally as a function of temperature using a bandgap reference current generator. In selected embodiments, the plurality of the most significant bits of the MFI value are applied to the trimming circuit to generate the charge pump control current. In other selected embodiments, the charge pump control current is generated by receiving an input reference current at a current mirror connected to receive the input reference current at diode-connected gate of a first field effect transistor (FET) device and to supply the input reference current under control of the MFI value to one or more gates of a plurality of second FET devices connected in parallel between a charge pump control current output and the ground supply reference voltage. In such embodiments, the first FET device may be a first unit-sized FET device, and the plurality of second FET devices may include a second unit-sized FET device and a plurality of differently sized FET devices that are source-drain connected between the charge pump control current output and the ground supply reference voltage and that have respective gate terminals respectively connected to receive the input reference current over a corresponding connection switch that is controlled by a trim control value from the MFI value. In other selected embodiments, the charge pump control current is generated by selectively applying a plurality of most significant bits of the MFI value as a corresponding plurality of trim control signals to a current mirror trimming circuit to generate the charge pump control current by adding or subtracting current to the input reference current under control of the plurality of trim control signals. In such embodiments, the plurality of most significant bits of the MFI value are the five most significant bits of the MFI value. In addition, the disclosed method filters the charge pump control current with a loop filter to produce a voltage control signal. The disclosed method also generates a PLL clock output signal with a voltage controlled oscillator in response to the voltage control signal. In addition, the disclosed method provides the PLL clock output signal to a feedback clock divider which is configured with the MFI value to produce the feedback clock signal for return to the phase-frequency detector. With the disclosed method, the charge pump dynamically scales an input reference current under control of the MFI value to generate the charge pump control current so that a PLL bandwidth of the PLL circuit adaptively tracks a frequency of the input reference signal and a frequency of the PLL clock output signal.

In yet another form, there is provided a phase locked loop (PLL) which includes a phase-frequency detector connected to receive an input reference signal and a feedback clock signal as inputs, a charge pump connected to receive a phase-frequency detector error output signal from the phase-frequency detector, a second order loop filter connected to receive a charge pump control current from the charge pump, a voltage controlled oscillator connected to receive a voltage control signal from the second order loop filter and configured to generate a PLL clock output signal, and a feedback clock divider connected to receive the PLL clock output signal and configured with a multiplication feedback integer (MFI) value to generate the feedback clock signal. As disclosed, the charge pump is configured to generate the charge pump control current which dynamically tracks the MFI value with a current bias circuit which scales an input reference current under control of the MFI value to generate the charge pump control current so that a PLL bandwidth of the PLL adaptively tracks a frequency of the input reference signal to the PLL and a frequency of the PLL clock output signal. In selected embodiments, the PLL may also include a bandgap reference current generator which generates the input reference current that varies proportionally as a function of temperature. In selected embodiments, the current bias circuit may include a current mirror connected to receive the input reference current at diode-connected gate of a first field effect transistor (FET) device and configured to generate the charge pump control current by supplying the input reference current under control of the MFI value to one or more gates of a plurality of second FET devices connected in parallel between a charge pump control current output and a ground supply reference voltage. In such embodiments, the first FET device may include a first unit-sized FET device, and the plurality of second FET devices may include a second unit-sized FET device and a plurality of differently sized FET devices that are source-drain connected between the charge pump control current output and the ground supply reference voltage and that have respective gate terminals respectively connected to receive the input reference current over a corresponding connection switch that is controlled by a trim control value from the MFI value.

A PLL method and apparatus are provided with a phase-frequency detector, charge pump, loop filter, voltage controlled ring oscillator, and feedback clock divider that is configured with a multiplication feedback integer (MFI) value for generating a PLL clock output signal, where the charge pump includes a current bias circuit which dynamically scales an input reference current under control of the MFI value to generate the charge pump control current so that a PLL bandwidth of the PLL adaptively tracks a frequency of the input reference signal and a frequency of the PLL clock output signal.

Various illustrative embodiments of the present invention have been described in detail with reference to the accompanying figures. While various details are set forth in the foregoing description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified block diagrams and flow charts illustrating design and operational details of a PLL system with associated circuit modules and/or elements for adjusting the PLL bandwidth with a dynamically adjustable charge pump current that is generated by applying MFI values to scale an input reference current without including every device feature or aspect in order to avoid limiting or obscuring the present invention. Such descriptions and representations are used by those skilled in the art to describe and convey the substance of their work to others skilled in the art, and the omitted details which are well known are not considered necessary to teach one skilled in the art of how to make or use the present invention. Some portions of the detailed descriptions provided herein are also presented in terms of algorithms and instructions that operate on data that is stored in a computer memory. In general, an algorithm refers to a self-consistent sequence of steps leading to a desired result, where a "step" refers to a manipulation of physical quantities which may, though need not necessarily, take the form of electrical or magnetic signals capable of being stored, transferred, combined, compared, and otherwise manipulated. It is common usage to refer to these signals as bits, values, elements, symbols, characters, terms, numbers, or the like. These and similar terms may be associated with the appropriate physical quantities and are merely convenient labels applied to these quantities. Unless specifically stated otherwise as apparent from the following discussion, it is appreciated that, throughout the description, discussions using terms such as "processing" or "computing" or "calculating" or "determining" or "displaying" or the like, refer to the action and processes of hardware or a computer system or a similar electronic computing device, that manipulates and transforms data represented as physical (electronic) quantities within registers and memories into other data similarly represented as physical quantities within the memories or registers or other such information storage, transmission or display devices.

In the foregoing specification, the invention has been described with reference to specific examples of embodiments of the invention. It will, however, be evident that various modifications and changes may be made therein without departing from the scope of the invention as set forth in the appended claims and that the claims are not limited to the specific examples described above.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals.

Those skilled in the art will recognize that boundaries between the above described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments.

Also for example, the examples, or portions thereof, may be implemented as soft or code representations of physical circuitry or of logical representations convertible into physical circuitry, such as in a hardware description language of any appropriate type.

Also, the invention is not limited to physical devices or units implemented in non-programmable hardware but can also be applied in programmable devices or units able to perform the desired device functions by operating in accordance with suitable program code, such as mainframes, minicomputers, servers, workstations, personal computers, notepads, personal digital assistants, electronic games, automotive and other embedded systems, cell phones and various other wireless devices, commonly denoted in this application as "computer systems."

However, other modifications, variations and alternatives are also possible. The specifications and drawings are, accordingly, to be regarded in an illustrative rather than in a restrictive sense.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. In addition, the term "coupled," as used herein, is not intended to be limited to a direct coupling or a mechanical coupling. Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A phase-locked loop, PLL, comprising:
a phase-frequency detector, PFD, connected to receive an input reference signal and a feedback clock signal as inputs and configured to produce a PFD error output signal;
a charge pump connected to receive the PFD error output signal as an input and configured to produce a charge pump control current which tracks a multiplication feedback integer, MFI, value;
a loop filter connected to receive the charge pump control current and configured to produce a voltage control signal by filtering the charge pump control current;
a voltage controlled ring oscillator which is connected to receive voltage control signal and configured to produce a PLL clock output signal; and
a feedback clock divider connected to receive the PLL clock output signal as an input and configured with the MFI value to produce the feedback clock signal for return to the phase-frequency detector,
where the charge pump comprises a current bias circuit which dynamically scales an input reference current under control of the MFI value to generate the charge pump control current so that a PLL bandwidth of the PLL adaptively tracks a frequency of the input reference signal and a frequency of the PLL clock output signal.

2. The phase-locked loop of claim 1, where the current bias circuit comprises a current mirror connected with a trimming circuit to generate the charge pump control current by adding or subtracting current to the input reference current under control of the MFI value.

3. The phase-locked loop of claim 2, where a plurality of the most significant bits of the MFI value are applied to the trimming circuit to generate the charge pump control current.

4. The phase-locked loop of any preceding claim, further comprising a bandgap reference current generator which generates the input reference current that varies proportionally as a function of temperature.

5. The phase-locked loop of claim 4, where the current bias circuit comprises a current mirror connected to receive the input reference current at diode-connected gate of a first field effect transistor, FET, device and configured to generate the charge pump control current by supplying the input reference current under control of the MFI value to one or more gates of a plurality of second FET devices connected in parallel between a charge pump control current output and the ground supply reference voltage.

6. The phase-locked loop of claim 5, where the first FET device has a unit size.

7. The phase-locked loop of claim 6, where the plurality of second FET devices comprises a first unit-sized FET device and a plurality of differently sized FET devices that are source-drain connected between the charge pump control current output and the ground supply reference voltage and that have respective gate terminals respectively connected to receive the input reference current over a corresponding connection switch that is controlled by a trim control value from the MFI value.

8. A method of operating a phase locked loop, PLL, circuit with adaptive bandwidth tracking, comprising:
generating a phase-frequency error measure at a phase-frequency detector by detecting a phase difference between an input reference signal and a feedback clock signal;
generating a charge pump control current which tracks a multiplication feedback integer, MFI, value in response to the phase-frequency error measure;
filtering the charge pump control current with a loop filter to produce a voltage control signal;
generating a PLL clock output signal with a voltage controlled oscillator in response to the voltage control signal; and
providing the PLL clock output signal to a feedback clock divider which is configured with the MFI value to produce the feedback clock signal for return to the phase-frequency detector,
where the charge pump dynamically scales an input reference current under control of the MFI value to generate the charge pump control current so that a PLL bandwidth of the PLL circuit adaptively tracks a frequency of the input reference signal and a frequency of the PLL clock output signal.

9. The method of claim 8, where generating the charge pump control current comprises: generating a reference current; and providing the reference current as an input to a current mirror connected with a trimming circuit to generate the charge pump control current by adding or subtracting current to the input reference current under control of the MFI value.

10. The method of claim 9, where generating the reference current comprises generating a current that varies proportionally as a function of temperature using a bandgap reference current generator.

11. The method of claim 9 or 10, where a plurality of the most significant bits of the MFI value are applied to the trimming circuit to generate the charge pump control current.

12. The method of any of claims 8 to 11, where generating the charge pump control current comprises receiving an input reference current at a current mirror connected to receive the input reference current at diode-connected gate of a first field effect transistor, FET, device and to supply the input reference current under control of the MFI value to one or more gates of a plurality of second FET devices connected in parallel between a charge pump control current output and the ground supply reference voltage.

13. The method of claim 12, where the first FET device comprises a first unit-sized FET device.

14. The method of claim 13, where the plurality of second FET devices comprises a second unit-sized FET device and a plurality of differently sized FET devices that are source-drain connected between the charge pump control current output and the ground supply reference voltage and that have respective gate terminals respectively connected to receive the input reference current over a corresponding connection switch that is controlled by a trim control value from the MFI value.

15. The method of any of claims 8 to 14, where generating the charge pump control current comprises selectively applying a plurality of most significant bits of the MFI value as a corresponding plurality of trim control signals to a current mirror trimming circuit to generate the charge pump control current by adding or subtracting current to the input reference current under control of the plurality of trim control signals.
